**Europäisches Patentamt**

**European Patent Office**

**Office européen des brevets**

(19)

(11) Veröffentlichungsnummer : **0 303 095 B1**

(12) **EUROPÄISCHE PATENTSCHRIFT**

(45) Veröffentlichungstag der Patentschrift :
12.06.91 Patentblatt 91/24

(51) Int. Cl.⁵ : **G01R 33/36**

(21) Anmeldenummer : **88111990.3**

(22) Anmeldetag : **26.07.88**

(54) **Probenkopf für NMR-Spektrometer.**

(30) Priorität : **04.08.87 DE 3725718**

(43) Veröffentlichungstag der Anmeldung :
**15.02.89 Patentblatt 89/07**

(45) Bekanntmachung des Hinweises auf die
Patenterteilung :
**12.06.91 Patentblatt 91/24**

(84) Benannte Vertragsstaaten :
**CH DE FR GB LI**

(56) Entgegenhaltungen :
**GB-A- 2 094 482**
**PROGRESS IN NMR SPECTROSCOPY, Band
12, Nr. 41-77, 1978, GB; D.I. HOULT: "The NMR
receiver: a description and analysis of Design", Seite 64**

(56) Entgegenhaltungen :
**PATENT ABSTRACTS OF JAPAN, Band 11, Nr.
68 (P-553) (2515), 28. Februar 1987; & JP A
61231444**
**PATENT ABSTRACTS OF JAPAN, Band 11, Nr.
9 (P-534) (2456), 10. Januar 1987; & JP A
61186842**

(73) Patentinhaber : **Bruker Analytische
Messtechnik GmbH
Silberstreifen
W-7512 Rheinstetten-Forchheim (DE)**

(72) Erfinder : **Dejon, Peter
Pfalzstr. 6
W-7512 Rheinstetten-Mörsch (DE)**
Erfinder : **Spraul, Manfred, Dr.
Am Grabenacker 9
W-7505 Ettlingen 6 (DE)**

(74) Vertreter : **KOHLER SCHMID + PARTNER
Patentanwälte
Ruppmannstrasse 27
W-7000 Stuttgart 80 (DE)**

## Beschreibung

Die Erfindung betrifft einen Probenkopf für NMR-Spektrometer mit einer auf einem Trägerrohr angeordneten HF-Spule, die sich am Ende von zwei parallelen, sich im wesentlichen in Axialrichtung des Trägerrohres erstreckenden, einen symmetrischen Doppelleitungsabschnitt bildenden Leitern befindet, und einer sich über wenigstens einen Abschnitt der beiden Leiter erstreckenden, auf der der Achse des Trägerrohres zugewandten Seite der beiden Leiter angeordneten Abschirmung.

Die HF-Spule des Probenkopfes für NMR-Spektrometer hat den Zweck, eine sich innerhalb des Trägerrohres befindende Probe durch Erzeugen eines die Probe durchsetzenden HF-Magnetfeldes anzuregen und danach die von den angeregten Spins der Probe erzeugten Signale zu empfangen. Dabei wirkt auf die Probe nicht nur das von der HF-Spule selbst erzeugte, weitgehend homogene HF-Magnetfeld ein, sondern auch das von den die HF-Spule speisenden Leitern erzeugte HF-Magnetfeld, das jedoch weder die Intensität noch die Phasenlage hat, die zur korrekten Anregung der Probe erforderlich ist. Es findet daher im Bereich der Leiter parasitäre Anregung der Probe statt, die zur Erzeugung von Störsignalen führt. Zu diesen Störsignalen gehören insbesondere die sogenannten Rotationsseitenbänder, die dadurch entstehen, daß eine innerhalb des Trägerrohres in Rotation versetzte Probe nicht genau zentrisch rotiert und sich daher gegenüber dem von den Leitern erzeugten, nicht homogenen HF-Magnetfeld mit der Rotationsfrequenz bewegt, so daß hier eine Modulation der erzeugten Signale mit der Rotationsfrequenz der Probe stattfindet. Die auf diese Weise erzeugten Störsignale sind dann besonders gravierend, wenn die Spektren von Substanzen zu messen sind, die sich in geringer Konzentration in einer wässrigen Lösung befinden, weil dann die von den Protonen des Wassers erzeugten Störsignale in der gleichen Größenordnung liegen die wie von den zu messenden Substanzen erzeugten Signale. Insbesondere bleiben diese Störsignale auch dann erhalten, wenn die von den Protonen des Lösungsmittels erzeugten Signale durch Sättigung der Protonenspins unterdrückt werden sollen.

Es ist bereits bekannt, den Einfluß des von den die HF-Spule speisenden Leitern erzeugten HF-Magnetfeldes auf die Probe durch eine zwischen den Leitern und der Probe angeordnete Abschirmung zu vermindern. So ist es beispielsweise aus dem "Journal of Magnetic Resonance" 72 (1987), Seiten 62 bis 167, bekannt, in das Trägerrohr für die HF-Spule ein mit einer gut leitenden, metallischen Schicht versehenes Rohr einzuführen, dessen metallische Schicht eine kreiszylindrische, elektrisch leitende Abschirmung bildet, die sich zwischen den Leitern der Probe befindet. Die Anbringung einer solchen Abschirmung innerhalb des Trägerrohres ist jedoch problematisch, weil der innerhalb des Trägerrohres zur Verfügung stehende Raum für die Aufnahme des Probengefäßes benötigt wird, das in dem Trägerrohr frei drehbar sein muß. Bei den ohnehin geringen Abmessungen des Trägerrohres steht daher in vielen Fällen nicht der Platz zur Verfügung, um ein solches zusätzliches, metallisch beschichtetes Rohr unterzubringen.

Es ist auch schon bekannt, Abschirmungen an der Außenseite des Trägerrohres anzuordnen, über die dann die zur HF-Spule führenden Leiter mit Abstand hinweggeführt werden. Diese Abschirmungen bestehen im wesentlichen aus metallischen, um das Trägerrohr herumgelegten Ringen.

Eine Schwierigkeit ergibt sich daraus, daß die HF-Spulen der Probenköpfe von NMR-Spektrometern Bestandteil eines abgestimmten Resonanzkreises sehr hoher Güte sind und die Abschirmung weder die Güte noch die Abstimmung der Resonanzkreis nachteilig beeinflussen darf. Dabei sind die zur Abstimmung der Resonanzkreise erforderlichen Kondensatoren an den von der Spule entfernten Enden der Leiter angeordnet, so daß diese Leiter mit ihren Induktivitäts- und Kapazitätswerten in den Resonanzkreis eingehen. Daher verbietet es sich, die Abschirmungen etwa an Masse zu legen, weil hierdurch das Resonanzverhalten des die HF-Spule enthaltenden Resonanzkreises in unzulässiger Weise verändert würde.

Alle diese Schwierigkeiten hatten zur Folge, daß durch die bisher bekannten Maßnahmen zu Abschirmung der Leiter deren störender Einfluß zwar vermindert werden konnte, die verbleibenden Störungen aber immer noch groß genug sind, um die Leistungsfähigkeit eines NMR-Spektrometers deutlich zu begrenzen. Daher liegt der Erfindung die Aufgabe zugrunde, einen Probenkopf für NMR-Spektrometer der eingangs genannten Art so weiterzubilden, daß eine bedeutende Verbesserung der Unterdrückung der Störungen, die von den von den Leitern erzeugten HF-Magnetfeldern ausgehen, erzielt wird.

Diese Aufgabe wird in überraschend einfacher Weise dadurch gelöst, daß die Abschirmung mit wenigstens einem Windungsabschnitt (16 ; 47, 57) der HF-Spule elektrisch leitend verbunden ist, der sich auf dem Nullpotential der auf der Doppelleitung zugeführten Gegentaktwelle befindet.

Bei einer mittels einer Doppelleitung symmetrisch gespeisten HF-Spule liegen an deren Enden um 180° gegeneinander phasenverschobene Wechselspannungen an, so daß entsprechend dem Spannungsabfall längs der Spule ein definierter Punkt existiert, an dem unabhängig von dem Augenblickswert der Spannungen an den Enden der Spule ein dem Nullwert der Wechselspannung entsprechendes Potential herrscht. Diese wechselspannungsfreie Stelle der Spule wird gewöhnlich als "kalter Punkt" bezeichnet. Wird nun die Abschirmung mit diesem kalten Punkt verbunden, wird sie auf dem in Bezug auf die Wechselspannung unveränderlichen Nullpotential gehalten und es wird dadurch ihre Abschirmwirkung bedeutend verbessert.

Die bedeutend verbesserte Abschirmwirkung ist nicht nur dann vorhanden, wenn die Abschirmung, wie bisher üblich, ein zur Achse des Trägerrohres konzentrisches, ringförmig geschlossenes Gebilde, insbesondere einen Kreiszylinder, darstellt, sondern es genügt, wenn die Abschirmung nur in einem den beiden Leitern benachbarten Bereich angeordnet ist. So sieht eine bevorzugte Ausführungsform der Erfindung vor, daß die Abschirmung von einem an der Außenseite des Trägerrohres angeordneten, sich zu den Leitern parallel erstreckenden Abschirmblech gebildet wird.

Die Anbringung eines solchen Abschirmbleches ist nicht nur besonders einfach, sondern es hat die Verwendung eines solchen Abschirmbleches auch noch den besonderen Vorteil, daß es aus dem gleichen Material bestehen kann wie die Drähte der HF-Spule. Wenn nämlich zur Abschirmung nur ein relative schmaler Blechstreifen benötigt wird, kann ein solcher Streifen leicht durch Verformen eines entsprechenden Drahtstückes hergestellt werden.

Für die Verbindung der Abschirmung mit dem kalten Punkt der HF-Spule ist es vorteilhaft, wenn der sich auf dem Nullpotential der Gegentaktwelle befindende, oder, anders ausgedrückt, den kalten Punkt der HF-Spule enthaltende Windungsabschnitt derjenigen Stelle benachbart ist, an der die beiden Leiter in die Windungen der HF-Spule übergehen, so daß möglichst keine besonderen, Leiter- oder Windungsabschnitte kreuzenden Verbindungen zwischen der Abschirmung und dem kalten Punkt der HF-Spule hergestellt werden müssen, sondern die Abschirmung unmittelbar bis an den den kalten Punkt der HF-Spule enthaltenden Windungsabschnitt der HF-Spule herangeführt werden kann, ohne daß andererseits die Abschirmung in den wirksamen Bereich der Windungen der Spule eingreift und dadurch wiederum die Homogenität des von der HF-Spule erzeugten, hochfrequenten Magnetfeldes beeinträchtigt.

Bei einer ersten bevorzugten Ausführungsform der Erfindung weist die HF-Spule zwei in Serie geschaltete Wicklungsabschnitte auf und es ist die Abschirmung mit dem die beiden Wicklungsabschnitte verbindenden Windungsabschnitt elektrisch leitend verbunden. Dabei kann die HF-Spule in bekannter Weise als Sattelspule mit zwei in Bezug auf das Trägerrohr einander diametral gegenüberliegenden, in Serie geschalteten Wicklungsabschnitten ausgebildet sein, die durch einen wenigstens einen der beiden Leiter kreuzenden Windungsabschnitt miteinander verbunden sind, mit dem dann ihrerseits die Abschirmung elektrisch leitend verbunden ist.

Bei einer zweiten bevorzugten Ausführungsform der Erfindung weist die HF-Spule zwei parallel geschaltete Wicklungsabschnitte auf und es ist die Abschirmung mit den die "kalten" Mittelpunkte der beiden Wicklungsabschnitte enthaltenden Windungsabschnitten der HF-Spule elektrisch leitend verbunden. Auch diese Ausbildung ist möglich, wenn die HF-Spule in bekannter Weise als Sattelspule ausgebildet ist, die dann zwei in Bezug auf das Trägerrohr einander diametral gegenüberliegende, parallel geschaltete Wicklungsabschnitte aufweist. Hierbei sind dann diese Wicklungsabschnitte so gestaltet, daß die die Mittelpunkte enthaltenden Windungsabschnitte zu den beiden Leitern benachbart angeordnet sind.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen

Fig. 1 die perspektivische Darstellung der HF-Spule eines Probenkopfes nach der Erfindung in stark vergrößertem Maßstab,

Fig. 2 die schematisch in der Abwicklung dargestellten HF-Spule nach Fig. 1.

Fig. 3 das Schaltbild der HF-Spule nach Fig. 1 in Verbindung mit Koppel- und Abstimmkondensatoren,

Fig. 4 eine weitere schematisch in der Abwicklung dargestellte HF-Spule für einen Probenkopf nach der Erfindung und

Fig. 5 das Schaltbild der HF-Spule nach Fig. 4 in Verbindung mit Koppel- und Abstimmkondensatoren.

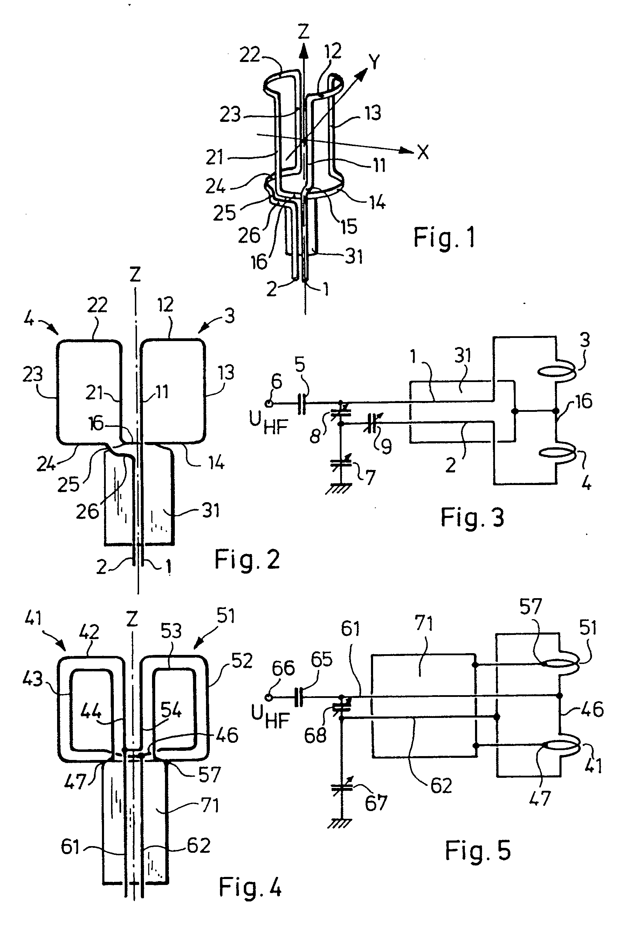

Bei der in den Fig. 1 bis 3 dargestellten HF-Spule handelt es sich um eine Art Helmholtz-Spule mit zwei im Abstand voneinander abgeordneten Wicklungsabschnitten 3, 4 von denen jeder nur eine Windung aufweist. Die beiden Wicklungsabschnitten 3, 4 sind so gebogen, daß sie sich an den Umfang eines nicht dargestellten Trägerrohres anschmiegen. Der erste dieser beiden Wicklungsabschnitte umfaßt einen ersten Windungsabschnitt 11, der sich im wesentlichen in Verlängerung eines Leiters 1 erstreckt, der parallel zur Achse Z des nicht näher dargestellten Trägerrohres angeordnet ist. An dem in Fig. 1 oberen Ende des Windungsabschnittes 11 schließt sich ein sich in Umfangsrichtung des Rohres erstreckender Windungsabschnitt 12 an, der von einem sich parallel zum ersten Windungsabschnitt 11 erstreckenden Windungsabschnitt 13 gefolgt wird, der jedoch in entgegengesetzer Richtung zum ersten Windungsabschnitt 11 verläuft und etwa die gleiche Länge wie dieser Windungsabschnitt hat. Daren schließt sich wiederum ein sich in Umfangsrichtung des nicht näher dargestellten Trägerrohres erstreckender Windungsabschnitt 14 an, der sich wiederum in Richtung auf den Leiter 1 und den ersten Windungsabschnitt 11 erstreckt und den Leiter 1 kreuzt, der am Übergang zum ersten Windungsabschnitt 11 eine Kröpfung 15 aufweist, so daß die Kreuzung berührungsfrei erfolgt. Es ist ersichtlich, daß die Windungsabschnitte 11, 12, 13, 14 einen geschlossenen Rahmen und damit eine vollständige Windung der HF-Spule bilden.

An diese erste Windung schließt sich eine zweite Windung an, die wiederum einen ersten Windungsabschnitt 21 aufweist, der sich an das Ende des den Leiter 1 kreuzenden Windungsabschnittes 14 der ersten Windung anschließt und sich parallel zu dem ersten Windungsabschnitt 11 wiederum in der Axialrichtung Z des nicht nicht näher dargestellten Trägerrohres erstreckt. An diesen ersten Abschnitt 21 schließen sich weitere Abschnitte 22, 23 und 24 an, die zu den entsprechenden Abschnitten- 12, 13, 14 der ersten Windung spiegelsymmetrisch angeordnet sind und von denen der Abschnitt 24 über eine Kröpfung 25 in einen Abschnitt 26 übergeht, der sich zu dem die beiden Windungen verbindenden Leiterabschnitt 16 parallel erstreckt, bevor er in den zweiten Leiter 2 übergeht, der ebenso wie der erste Leiter 1 dazu dient, der HF-Spule einen HF-Impuls zuzuführen oder das von der HF-Spule empfangene Signal an eine Empfangseinrichtung weiterzuleiten.

Fig. 2 zeigt nochmals schematisch die soeben beschriebene HF-Spule, die zwei durch den Windungsabschnitt 16 miteinander verbundene jeweils eine vollständige Windung der HF-Spule bildende Wichlungdabschnitte 3 und 4 aufweist, von denen der erste Wichlungsabschnitt 3 die Windungsabschnitte 11 bis 14 und der zweite Wicklungsabschnitt 4 die Windungsabschnitte 21 bis 24 umfaßt. Die beiden Leiter 1 und 2 führen jeweils zu den von dem verbindenden Windungsabschnitt 16 entfernten Ende der Wicklungsabschnitte 3 und 4, so daß die beiden Wicklungsabschnitte in Serie zueinander geschaltet sind, wie es das Schaltbild nach Fig. 3 zeigt. Von den beiden Leitern ist der erste Leiter 1 über einen Kondensator 5 mit einer Klemme 6 verbunden, die ihrerseits wahlweise mit einer nicht näher dargestellten Sende- oder Empfangseinrichtung verbindbar ist. Der zweite Leiter 2 ist über einen abstimmbaren Kondensator 7 an Masse gelegt. Ein zweiter abstimmbarer Kondensator 8 befindet sich zwischen den beiden Leitern 1 und 2 und ein weiterer abstimmbarer Kondensator 9 in dem zweiten Leiter 2. Mit dem zu den beiden Wicklungsabschnitten 3, 4 parallel geschalteten Kondensator 8 läßt sich der von den beiden in Serie geschalteten Wicklungsabschnitten 3, 4 und dem Kondensator 8 gebildete Parallel-Resonanzkreis auf die Frequenz des zu übertragenden HF-Signales abstimmen. Der abstimmbare Kondensator 9, der zu dem einen Wicklungsabschnitt 4 in Serie geschaltet ist, erlaubt es, Unterschiede zwischen den Wicklungsabschnitten 3 und 4 so auszugleichen, daß der die beiden Wicklungsabschnitte 3, 4 verbindende Windungsabschnitt 16 auf einem in Bezug auf die Hochfrequenz-Spannung mittleren Potential liegt, also auf einem festen Nullpotential in Bezug auf die an die Leiter 1 und 2 im Gegentakt anliegenden HF-Spannungen. Da demnach auf dem die Wicklungsabschnitte 3 und 4 verbindenden Windungsabschnitt 16 keine Wechselspannung auftritt, wird diese Stelle der HF-Spule auch als "kalter Punkt" bezeichnet. Der verstellbare Kondensator 7, der den zweiten Leiter 2 mit Masse verbindet, dient in Verbindung mit dem in dem ersten Leiter 1 angeordneten Kondensator 5 dazu, das sich im Betrieb einstellende Potential am kalten Punkt 16 festzulegen.

Nach der Erfindung ist mit dem den kalten Punkt enthaltenden Windungsabschnitt 16 eine Abschirmung 31 verbunden, die, wie aus Fig. 1 ersichtlich, von einem aus einem Material mit hoher elektrischer Leitfähigkeit bestehenden Streifen gebildet wird, der sich parallel zu den beiden Leitern 1, 2 erstreckt und zwischen diesen Leitern und der Achse Z des nicht näher dargestellten Trägerrohres angeordnet ist. Da diese Abschirmung mit dem kalten Punkt der HF-Spule verbunden ist, liegt sie auf einem gegenüber den Leitern 1, 2 festen Potential, mit dem Ergebnis, daß die Abschirmung selbst keinen Wechselspannungen ausgesetzt ist und daher auch kein Wechselfeld im Inneren des Trägerrohres erzeugen kann. Vielmehr schirmt sie die beiden Leiter 1, 2 gegen das Innere des Trägerrohres mit Sicherheit ab, zumal bei richtiger Abstimmung der HF-Spule die beiden Leiter 1 und 2 gegenphasige Spannungen führen und daher die Abschirmung auch gegenüber diesen Leitern "kalt"ist. Die geringen Kapazitäten, die zwischen den beiden Leitern 1 und 2 und der Abschirmung herrschen und die Resonanz-Abstimmung der HF-Spule eingehen, können leicht durch entsprechende Einstellung der oben beschriebenen Kondensatoren 7 bis 9 kompensiert werden.

Der beschriebene Probenkopf ist nicht nur besonders wirksam, sondern zugleich aus sehr einfach im Aufbau. Hierfür ist wichtig, daß bei der beschriebenen Gestaltung der HF-Spule der den kalten Punkt enthaltende Windungsabschnitt 16 derjenigen Stelle benachbart ist, an der die beiden Leiter 1, 2 in die Wicklungsabschnitte 3, 4 der HF-Spule übergehen. Daher ist es möglich, einen Rand der Abschirmung 31 einfach mit diesem Windungsabschnitt 16 zu verbinden, was den weiteren Vorteil hat, daß die Abschirmung unmittelbar am Rand HF-Spule beginnt und daher die Probe gegen den Einfluß der HF-Felder wirksam schützt, die von den außerhalb der Spule verlaufenden Leitern erzeugt werden. Gleichzeitig wird aber auch der wirksame Querschnitt der HF-Spule durch die Abschirmung nicht beeinträchtigt.

Bei der in den Fig. 4 und 5 dargestellten Ausführungsform der Erfindung weist die HF-Spule nicht zwei in Serie geschaltete, sondern zwei parallel geschaltete Wicklungsabschnitte 41, 51 auf, die jeweils aus zwei Windungen 42, 43 bzw. 52, 53 bestehen, die jeweils rahmenförmig ineinanderliegend angeordnet sind. Der eine Leiter 61 ist ähnlich wie bei der HF-Spule nach Fig. 1 an die beiden nebeneinanderliegenden Windungsabschnitte der äußeren Windungen 42, 52 angeschlossen, die sich parallel zur Achse Z des nicht näher dargestellten Trägerrohres erstrecken, während der andere Leiter 62 an einen die inneren Windungen 43, 53 miteinander verbindenden, sich quer zu den Leitern 61, 62 erstreckenden Windungsabschnitt 46 angeschlossen ist.

Wie bei dem zuvorbeschriebenen Ausführungsbeispiel ist auch hier wieder der eine Leiter 61 über einen Kondensator 65 mit einer Klemme 66 verbunden und es sind abstimmbare Kondensatoren 67 und 68 zwischen Masse und der Leitung 62 bzw. zwischen den Leitern 61, 62 angeordnet. Wie das Schaltbild nach Fig. 5 erkennen läßt, bildet der Kondensator 68 mit jeder der beiden Wicklungsabschnitte 41, 51 einen Parallelschwingkreis, so daß die beiden Parallelschwingkreise gleichzeitig mittels des Kondensators 68 auf die Frequenz des HF-Signals abgestimmt werden können. Gegebenenfalls könnte auch hier wieder zu einer der beiden Wicklungen ein abstimmbarer Kondensator in Serie geschaltet sein, der einen genauen Abgleich der beiden Resonanzkreise ermöglicht. Der abstimmbare Kondensator 67 dient wieder zum Einstellen des Nullpotentials für die der HF-Spule zugeführte Wechselspannung, die wiederum auf den beiden Leitern 61, 62 im Gegentakt vorliegt.

Infolge der Parallelschaltung der beiden Wicklungsabschnitte 41, 51 liegt diesmal das in Bezug auf die angelegte Wechselspannung neutrale Potential, also der kalte Punkt der HF-Spule, nicht zwischen den beiden Wicklungsabschnitten 41, 51, sondern, da an jeder der Wicklungsabschnitte die gesamte HF-Spannung ansteht, jeweils in der Mitte dieser beiden Wicklungsabschnitte, also an den Punkten 47, 57. Demgemäß ist auch die Abschirmung 71 mit diesen Punkten elektrisch leitend verbunden. Wie in Fig. 4 schematisch dargestellt, liegen die kalten Punkte 47, 48 bei dem vorstehend beschriebenen Wicklungsaufbau an den einander zugewandten Ecken der äußeren Windungen 42, 52, die auch den leitern 61, 62 benachbart sind. Daher ist es wieder möglich, die Abschirmung 71 unmittelbar mit den die kalten Punkte 47, 57 enthaltenden Windungsabschnitten direkt elektrisch leitend zu verbinden, insbesondere zu verlöten.

Auch bei diesem Ausführungsbeispiel ist die Abschirmung 71 als schmaler Streifen aus einem Material sehr hoher elektrischer Leitfähigkeit hergestellt, beispielsweise aus einer suszeptibilitäts-kompensierten Kupferfolie, und es werden auch hier die oben behandelten Vorteile erzielt, die sich aus der Verbindung der Abschirmung mit dem kalten Punkt der HF-Spule und der speziellen Ausbildung und der Anordnung dieser Abschirmung ergeben.

Es versteht sich, daß die Erfindung nicht auf die dargestellten Ausführungsbeispiele beschränkt ist, sondern Abweichungen davon möglich sind, ohne den Rahmen der Erfindung zu verlassen. Wie bereits oben dargelegt, werden die wesentlichen Vorteile allein durch die Maßnahme erzielt, daß die Abschirmung mit mindestens einem kalten Punkt der HF-Spule verbunden ist und dadurch auf einem bezüglich der auftretenden HF-Spannungen festen Potential gehalten wird, ohne daß es dabei zu Gebilden kommt, die eine störende Eigenresonanz haben können. Dabei bereitet die Notwendigkeit, einen elektrisch leitende Verbindung zu der HF-Spule herzustellen, nicht etwa Schwierigkeiten, sondern gestattet es vielmehr, die Abschirmung unmittelbar an die wirksamen Abschnitte der HF-Spule angrenzend anzuordnen. Dem Fachmann steht es dann auch frei, die Gestalt der Abschirmung nach den jeweiligen Erfordernissen zu wählen und insbesondere anstelle der als Ausführungsbeispiele dargestellten band- oder streifenartigen Gebilde auch das Trägergrohr umgebende, ring- oder zylinderförmige Gebilde vorzusehen. Aus alledem geht hervor, daß dem Fachmann viele Möglichkeiten zur Verfügung stehen, die Erfindung nach seinem Belieben abzuwandeln, um den jeweiligen Erfordernissen optimal zu genügen, ohne dabei den Rahmen der Erfindung zu verlassen.

**Ansprüche**

1. Probenkopf für NMR-Spektrometer mit einer auf einem Trägerrohr angeordneten HF-Spule, die sich am Ende von zwei parallelen, sich im wesentlichen in Axialrichtung des Trägerrohres erstreckenden, einen symmetrischen Doppelleitungsabschnitt bildenden Leitern (1, 2 ; 61, 62) befindet, und einer sich über wenigstens einen Abschnitt der beiden Leiter erstreckenden, auf der der Achse des Trägerrohres zugewandten Seite der beiden Leiter angeordneten Abschirmung (31 ; 71), dadurch gekennzeichnet, daß die Abschirmung (31 ; 71) mit wenigstens einem Windungsabschnitt (16 ; 47, 57) der HF-Spule elektrisch leitend verbunden ist, der sich auf dem Nullpotential der auf der Doppelleitung zugeführten Gegentaktwelle befindet.

2. Probenkopf nach Anspruch 1, dadurch gekennzeichnet, daß der sich auf dem Nullpotential der Gegentaktwelle befindende Windungsabschnitt (16 ; 47, 57) derjenigen Stelle benachbart ist, an der die beiden Leiter (1, 2 ; 61, 62) in die Windungen (3, 4 ; 41, 51) der HF-Spule übergehen.

3. Probenkopf nach Anspruch 1 oder 2, dadurch gekennzeichnet, daß die HF-Spule zwei in Serie geschaltete Wicklungsabschnitte (3, 4) aufweist und die Abschirmung (31) mit dem die beiden Wicklungsabschnitte (3, 4) verbindenden Windungsabschnitt (16) elektrisch leitend verbunden ist.

4. Probenkopf nach `Anspruch 3, dadurch gekennzeichnet, daß die HF-Spule in bekannter Weise als Sattelspule mit zwei in Bezug auf das Trägerrohr einander diametral gegenüberliegenden, in Serie geschalteten Wicklungsabschnitten (3, 4) ausgebildet ist, die durch einen wenigstens einen der beiden Leiter kreuzenden Windungsabschnitt (16) miteinander verbunden sind, und daß die Abschirmung (31) mit diesem Windungsabschnitt (16) elektrisch leitend verbunden ist.

5. Probenkopf nach Anspruch 1 oder 2, dadurch gekennzeichnet, daß die HF-Spule zwei parallel geschaltete Wicklungsabschnitte (41, 51) aufweist und die Abschirmung (71) mit den die Mittelpunkte (47, 57) der beiden Wicklungsabschnitte (41, 51) enthaltenden Windungsabschnitten der beiden Wicklungsabschnitte (41, 51) der HF-Spule elektrisch leitend verbunden ist.

6. Probenkopf nach Anspruch 5, dadurch gekennzeichnet, daß die HF-Spule in bekannter Weise als Sattelspule mit zwei in Bezug auf das Trägerrohr einander diametral gegenüberliegenden, parallel geschalteten Wicklungsabschnitten (41, 51) ausgebildet ist, deren die Mittelpunkte (47, 57) enthaltenden Windungsabschnitte zu den beiden Leitern (61, 62) benachbart angeordnet sind.

7. Probenkopf nach einem der vorhergehenden Ansprüche, dadurch gekennzeichnet, daß die Abschirmung (31 ; 71) von einem an der Außenseite des Trägerrohres angeordneten, sich zu den Leitern (1, 2 ; 61, 62) parallel erstreckenden Abschirmblech gebildet wird.

8. Probenkopf nach Anspruch 7, dadurch gekennzeichnet, daß das Abschirmblech (31 ; 71) aus dem gleichen Material besteht wie die Drähte der HF-Spule.

## Claims

1. Probe for NMR spectrometers with an r.f. coil located on a support tube wherein the r.f. coil is located at the end of two parallel conductors extending substantially axially of the support tube and forming a symmetrical two-conductor line section (1, 2 ; 61, 62) and a shielding (31, 71) extending over a portion of the two conductors on the side of the latter facing the axis of the support tube, characterized in that the shielding (31, 71) is electrically conductively connected to at least one turn section (16 ; 47, 57) of the r.f. coil, which turn section is at the zero potential of the push-pull wave supplied on the double line.

2. Probe according to claim 1, characterized in that the turn section (16 ; 47, 57) at the zero potential of the push-pull wave is adjacent to that side at which the two conductors (1, 2 ; 61, 62) pass into the turns (3, 4 ; 41, 51) of the r.f. coil.

3. Probe according to claims 1 or 2, characterized in that the r.f. coil has two series-connected winding sections (3, 4) and the shielding (31) is electrically conductively connected to the turn section (16) connecting the two winding sections (3, 4).

4. Probe according to claim 3, characterized in that in known manner the r.f. coil is constructed as a saddle coil with two series-connected winding sections (93, 4), which diametrically face one another with respect to the support tube and which are interconnected by a turn section (16) crossing at least one of the two conductors and that the shielding is electrically conductively connected to the said turn section (16).

5. Probe according to claim 1 or 2, characterized in that the r.f. coil has two parallel connected winding sections (41, 51) and the shielding (71) is electrically conductively connected to the turn sections of the two winding sections (41, 51) of the r.f. coil containing the centres (47, 57) of the said two winding sections (41, 51).

6. Probe according to claim 5, characterized in that in known manner the r.f. coil is constructed as a saddle coil with two parallel-connected winding sections (41, 51), which diametrically face one another with respect to the support tube and whose turn sections containing the centres (47, 57) are located adjacent to the two conductors (61, 62).

7. Probe according to one of the preceding claims, characterized in that the shielding (31, 71) is formed by a shield plate extending parallel to the conductors (1, 2 ; 61, 62) and positioned on the outside of the support tube.

8. Probe according to claim 7, characterized in that the shield plate (31, 71) is made from the same material as the wires of the r.f. coil.

## Revendications

1. Tête de mesure pour spectromètre RMN, comportant une bobine HF disposée sur un tube de support situé à l'extrémité de deux conducteurs parallèles (1, 2 ; 61, 62), qui s'étendent sensiblement dans la direction axiale du tube de support et forment une section de ligne symétrique double, et un blindage (31 ; 71), qui s'étend sur au moins une partie des deux conducteurs et est disposé sur le côté de deux conducteurs, tourné à l'opposé de l'axe du tube de support, caractérisée par le fait que le blindage (31 ; 71) est relié d'une manière électriquement conductrice à un élément de spire (16 ; 47, 57) de la bobine HF, lequel élément se trouve au potentiel zéro des ondes en opposition de phase envoyées à la ligne double.

2. Tête de mesure suivant la revendication 1, caractérisée par le fait que l'élément de spire (16 ; 47;

57) placé au potentiel nul des ondes en opposition de phase est voisin de l'emplacement au niveau duquel les deux conducteurs (1, 2 ; 61, 62) se prolongent par les spires (3, 4 ; 41, 51) de la bobine HF.

3. Tête de mesure suivant la revendication 1 ou 2, caractérisée par le fait que la bobine HF comporte deux sections d'enroulement (3, 4) branchées en série et que le blindage (31) est relié d'une manière électriquement conductrice à l'élément de spire (16) qui relie les deux sections d'enroulement (3, 4).

4. Tête de mesure suivant la revendication 3, caractérisée par le fait que la bobine HF est agencée, de façon connue, sous la forme d'une bobine en sellette comportant deux sections d'enroulement (3, 4) diamétralement opposées sur le tube de support, branchées en série et reliées entre elles par au moins un élément de spire (16) qui croise au moins l'un des deux conducteurs, et que le blindage (31) est relié d'une manière électriquement conductrice à cet élément de spire (16).

5. Tête de mesure suivant la revendication 1 ou 2, caractérisée par le fait que la bobine HF comporte deux sections d'enroulement (41, 51) branchées en parallèle et que le blindage (71) est relié d'une manière électriquement conductrice aux éléments de spire des deux sections d'enroulement (41, 51), qui contiennent les centres (47, 57) de ces deux sections d'enroulement (41, 51).

6. Tête de mesure suivant la revendication 5, caractérisée par le fait que la bobine HF est réalisée de façon connue sous la forme d'une bobine en sellette comportant deux sections d'enroulement (41, 51), qui sont diamétralement opposées sur le tube de support et sont branchées en parallèle et dont les éléments de spire contenant les centres (47, 57) sont disposés au voisinage des deux conducteurs (61, 62).

7. Tête de mesure suivant l'une des revendications précédentes, caractérisée par le fait que le blindage (31 ; 71) est formé par une tôle de blindage qui est disposée sur la face extérieure du tube de support et s'étend parallèlement aux conducteurs (1, 2 ; 61, 64).

8. Tête de mesure suivant la revendication 7, caractérisée par le fait que la tôle de blindage (31 ; 71) est formée du même matériau que les fils de la bobine HF.

Fig. 1

Fig. 2

Fig. 3

Fig. 4

Fig. 5